# EUROPÄISCHE PATENTANMELDUNG

(11) **EP 4 221 469 A1**
(43) Veröffentlichungstag der Anmeldung: **02.08.2023**
(21) Anmeldenummer: 22153618.8
(22) Anmeldetag: 27.01.2022
(51) Int. Cl.: H05K 1/02, B62D 5/04, H05K 3/00

(54) **VERFAHREN ZUR HERSTELLUNG EINER STEUERSCHALTUNG FÜR EIN LENKSYSTEM EINES KRAFTFAHRZEUGS, VERFAHREN ZUR HERSTELLUNG EINES LENKSYSTEMS FÜR EIN KRAFTFAHRZEUG, STEUERSCHALTUNG FÜR EIN LENKSYSTEM EINES KRAFTFAHRZEUGS UND LENKSYSTEM FÜR EIN KRAFTFAHRZEUG**

(71) Anmelder: thyssenkrupp Presta Aktiengesellschaft, 9492 Eschen (LI); Thyssenkrupp AG, 45143 Essen (DE)
(72) Erfinder: Kirmsse, Helmut, 9494 Schaan (LI)
(74) Vertreter: thyssenkrupp Intellectual Property GmbH

(57) **Zusammenfassung**

Die vorliegende Erfindung betrifft ein Verfahren zur Herstellung einer Steuerschaltung (1) für ein Lenksystem (8) eines Kraftfahrzeugs, umfassend eine halbflexible Leiterplatte (2), die ein isolierendes Trägermaterial mit darauf angeordneten Leiterbahnen (22) aus einem leitfähigen Material aufweist, die mit elektrischen Bauteilen (3) verbunden sind, wobei die Leiterplatte (2) zumindest zwei im wesentlichen starre Leiterplattenabschnitte (23) aufweist, die über einen biegbaren Verbindungsabschnitt (24) miteinander verbunden sind. Um eine verbesserte Fertigung mit geringerem Aufwand und höherer Sicherheit zu ermöglichen, schlägt die Erfindung vor, dass in dem Verbindungsabschnitt (24) durch zumindest abschnittweise Erwärmung des Trägermaterials auf eine Umformtemperatur eine thermische Modifizierung (25) erzeugt wird zur Reduzierung der Biegesteifigkeit.

## Beschreibung

### Stand der Technik

Die Erfindung betrifft ein Verfahren zur Herstellung einer Steuerschaltung für ein Lenksystem eines Kraftfahrzeugs, umfassend eine halbflexible Leiterplatte, die ein isolierendes Trägermaterial mit darauf angeordneten Leiterbahnen aus einem leitfähigen Material aufweist, die mit elektrischen Bauteilen verbunden sind, wobei die Leiterplatte zumindest zwei im Wesentlichen starre Leiterplattenabschnitte aufweist, die über einen biegbaren Verbindungsabschnitt miteinander verbunden sind. Eine Leiterplatte, ein Verfahren zur Herstellung einer Steuerschaltung mit einer derartigen Leiterplatte sind ebenfalls Gegenstand der Erfindung.

Ein elektrisches Servo-Lenksystem oder ein Steer-by-wire-Lenksystem eines Kraftfahrzeugs weist elektrische Baugruppen auf, wie beispielsweise Sensoreinrichtungen, einen HilfskraftAntrieb, einen Feedback-Aktuator oder dergleichen. Diese werden von mindestens einer elektronischen Steuerschaltung des Lenksystems angesteuert. Von der Steuerschaltung werden beispielsweise in eine Lenkeingabe eigegebene Lenkbefehle erfasst und in elektrische Steuersignale umgewandelt, und in einer elektrischen Servo- oder Hilfskraftlenkung wird von der Steuerschaltung ein elektrischer Hilfskraftantrieb zur motorischen Unterstützung einer manuellen Lenkeingabe angesteuert. In einem Steer-by-wire-Lenksystem, welches keine direkte mechanische Verbindung zwischen einer manuellen Lenkeingabe und den lenkbaren Rädern aufweist, kann von der Steuereinheit ein elektrischer Feedback-Antrieb angesteuert werden, der ein motorisches Feedback-Moment in die manuelle Lenkeingabe einkoppeln kann, um eine von der Fahrsituation abhängige mechanische Rückmeldung von den lenkbaren Rädern zu simulieren.

Die einzelnen elektronischen Bauteile der Steuerschaltung sind auf einer Leiterplatte angeordnet, die als mechanischer Träger dient und Leiterbahnen zur elektrischen Verbindung der Bauteile aufweist. Die Leiterplatte, die gleichbedeutend auch als Platine oder PCB (printed circuit board) bezeichnet wird, weist einen flächig erstreckten Grundkörper aus einem isolierendes Trägermaterial, beispielsweise einem glasfaserverstärkten Kunststoff (GFK) auf. Das Trägermaterial weist auf mindestens einer Seite aus einem leitfähigen Material, üblicherweise aus Kupfer ausgebildete Leiterbahnen auf. Die Bauteile werden mit den Leiterbahnen verlötet.

Um ein möglichst kompakte und bauraumsparende Lenksystem eines Kraftfahrzeugs realisieren zu können, ist es bekannt, die Steuerschaltung zusammenfaltbar auszugestalten, um diese besser in einem vorhandenen, knappen Bauraum unterbringen zu können. Hierzu ist in der DE 10 2019 128 594 A1 oder der US 11,109,478 B1 die Verwendung einer halbflexiblen Leiterplatte beschrieben, bei der mindestens zwei starre Leiterplattenabschnitte über einen flexiblen, biegbaren Verbindungsabschnitt verbunden sind. Durch Biegung des Verbindungsabschnitts kann die Leiterplatte platzsparend abgeknickt oder gefaltet werden.

Zur Herstellung des biegbaren Verbindungabschnitts wird in dem genannten Stand der Technik vorgeschlagen, die Leiterplatte durch Fräsen einzufurchen. Um biegbare Elemente zu erzeugen, wird konkret ein präzisionsgesteuertes Tiefenfräsen der Kupfer-Leiterbahnen vorgeschlagen. Nachteilig daran ist der hohe Aufwand, der für die präzise Einbringung der Furchen durch spanabhebende Verfahren wie Fräsen erforderlich ist. Außerdem können die beim Fräsen auftretenden Vibrationen und mechanischen Belastungen potentiell schädlich sein.

Angesichts der vorangehend erläuterten Problematik ist es eine Aufgabe der vorliegenden Erfindung, eine verbesserte Fertigung mit geringerem Aufwand und höherer Sicherheit zu ermöglichen.

### Darstellung der Erfindung

Diese Aufgabe wird erfindungsgemäß gelöst durch ein Verfahren zur Herstellung einer Steuerschaltung für ein Lenksystem mit den Merkmalen des Anspruchs 1 und ein Verfahren zur Herstellung eines Lenksystems gemäß Anspruch 12, sowie durch eine Steuerschaltung gemäß Anspruch 13 und ein Lenksystem gemäß Anspruch 15. Vorteilhafte Weiterbildungen ergeben sich aus den Unteransprüchen.

Bei einem Verfahren zur Herstellung einer Steuerschaltung für ein Lenksystem eines Kraftfahrzeugs, umfassend eine halbflexible Leiterplatte, die ein isolierendes Trägermaterial mit darauf angeordneten Leiterbahnen aus einem leitfähigen Material aufweist, die mit elektrischen Bauteilen verbunden sind, wobei die Leiterplatte zumindest zwei im wesentlichen starre Leiterplattenabschnitte aufweist, die über einen biegbaren Verbindungsabschnitt miteinander verbunden sind, ist erfindungsgemäß vorgesehen, dass in dem Verbindungsabschnitt durch zumindest abschnittweise Erwärmung des Trägermaterials auf eine Umformtemperatur eine thermische Modifizierung erzeugt wird zur Reduzierung der Biegesteifigkeit.

Mittels des erfindungsgemäßen Verfahrens wird ein einheitlich flächenhaft durchgehendes, ebenes Leiterplattenmaterial, welches gleichbedeutend als Leiterplattenrohling bezeichnet wird, bearbeitet, um einen zwischen mindestens zwei Leiterplattenabschnitten einen einstückig ausgebildeten Verbindungsabschnitt zu erzeugen, der relativ zu diesen Leiterplattenabschnitten flexibler bzw. biegeweicher ist. Konkret erfolgt erfindungsgemäß dazu in dem Verbindungsabschnitt eine thermische Behandlung des Trägermaterials, um eine mechanische Schwächung zu erzeugen, welche es ermöglicht, die relativ starren Leiterplattenabschnitte um eine in dem Verbindungsabschnitt liegende Biegelinie relativ zueinander scharnierartig zusammen zu biegen. Dadurch ist es möglich, die auf diese Weise erzeugte halbflexible Leiterplatte kompakt zusammenzufalten.

Erfindungsgemäß wird der Verbindungsabschnitt zur lokalen Erhöhung der Flexibilität lokal thermisch modifiziert. Die thermische Modifikation umfasst eine Bearbeitung durch extern eingeleitete Wärme, wodurch eine lokal definierte Erwärmung bzw. Erhitzung im Bereich des Verbindungsabschnitts erfolgt. Durch das Erwärmen kann das Trägermaterial thermisch erweicht werden, mit anderen Worten in einen schmelzweichen, teigigen oder zähflüssigen Zustand mit geringerer Viskosität gebracht werden, so eine einfache plastische Umformung ermöglicht wird. Auf diese Weise kann mit geringem Aufwand eine plastische Formänderung des Trägermaterials erzeugt werden, beispielsweise eine lokale Verringerung der Dicke des Trägermaterials. Zur Dickenreduzierung kann beispielsweise ein Formwerkzeug, wie etwa ein Prägestempel oder dergleichen, in den erweichten Bereich mechanisch eingeformt werden. Dadurch kann eine beispielsweise eine rinnen- oder nutförmige Vertiefung ausgebildet werden, so dass eine Art Filmscharnier oder Filmgelenk gebildet wird, welches eine einstückige biegbare Verbindung zwischen den Leiterplattenabschnitten zur Verfügung stellt.

Dabei ist es denkbar und möglich, dass der Prägestempel selbst erwärmt ist und dadurch die lokal definierte Erwärmung im Bereich des Verbindungsabschnitts bewirkt. Die Erwärmung des Prägestempels kann dabei auf verschiedene Arten erfolgen. So kann eine Vorab-Erwärmung erfolgen. Es kann auch eine Erwärmung des Prägestempels vor und/oder während der plastischen Umformung mittels direkt eingeleitetem Stromfluss erzeugt werden.

Es ist denkbar und möglich, alternativ oder zusätzlich zur plastischen Umformung im thermisch erweichten Zustand eine Materialabtragung vorzusehen. Ein thermisches Abtragen kann beispielsweise durch einen schichtweisen Materialabtrag mittels Laserstrahlung, insbesondere auch mittels ultrakurzer Laserimpulse, erfolgen, wobei Material verdampft. Alternativ ist es denkbar und möglich, thermisch erweichtes Material auf andere Weise abzutragen, beispielsweise mechanisch.

Das Trägermaterial weist im Verbindungsabschnitt bevorzugt lediglich auf einer seiner beiden Oberflächen Leiterbahnen auf, definitionsgemäß auf seiner gleichbedeutend auch als Leiterbahnseite bezeichneten Oberseite. Diese können, wie dies von Leiterplatten bekannt ist, beispielsweise auflaminierte Kupferbahnen umfassen, auf welche die elektrischen Bauteile zur Erzeugung einer elektrischen und mechanischen Verbindung aufgelötet sind. Die erfindungsgemäße thermische Modifikation erfolgt bevorzugt von der den Leiterbahnen abgewandten Rück- oder Unterseite der Leiterplatte aus, wo das Trägermaterial nach außen frei liegt, und die gleichbedeutend auch als Trägermaterial- oder Trägerplattenseite bezeichnet wird. Dadurch kann die Wärme zur thermischen Bearbeitung direkt in das Trägermaterial eingebracht werden. Dabei ist es insbesondere auch möglich, während der lokalen Erwärmung des Trägermaterials die Leiterbahnen von der Oberseite zu kühlen, so dass keine potentiell schädliche Erwärmung der Leiterbahnen auftritt. Die thermische Modifikation bleibt definiert auf das isolierende Trägermaterial begrenzt.

Die Leiterplatte kann vorzugsweise vor der thermischen Modifikation mit den elektrischen Bauteilen bestückt sein, die im Bereich der starren Leiterplattenabschnitte auf die Leiterbahnen aufgelötet sind. Bei der erfindungsgemäß lokal begrenzten thermischen Modifikation im Verbindungabschnitt werden die Leiterplattenabschnitte mit den Lötverbindungen nicht erwärmt.

Ein Vorteil der Erfindung ist, dass die plastische Formänderung im thermisch erweichten Zustand einen relativ geringen Energieeintrag erfordert. Der fertigungstechnische Aufwand ist geringer als bei der im Stand der Technik vorgeschlagenen Dickenreduzierung durch spanabhebende Bearbeitung wie Fräsen oder dergleichen. Bei der erfindungsgemäßen thermischen Umformung ist in vorteilhafter Weise die mechanische Beanspruchung der Leiterplatte durch Vibrationen und mechanische Spannungen deutlich geringer als im Stand der Technik. Ein besonderer Vorteil ist, dass die Bearbeitungstemperatur so vorgegeben werden kann, dass ausschließlich das Trägermaterial thermisch bearbeitet wird, die Leiterbahnen jedoch nicht umgeformt oder verändert werden, und dadurch eine versehentliche Beschädigung bei der Erzeugung des Verbindungsabschnitts praktisch ausgeschlossen werden kann. Im Gegensatz dazu können im Stand der Technik bei der spanabhebenden Fertigung bereits geringste Abweichungen beim Fräsen zu einer Beschädigung oder Zerstörung der Leiterbahnen führen. Folglich ist die Bearbeitung schonender, und die Fertigungssicherheit kann durch das erfindungsgemäße Verfahren erhöht werden.

Es ist bevorzugt, dass die Umformtemperatur oberhalb einer Glasübergangstemperatur des Trägermaterials liegt. Die Glasübergangstemperatur Tg, die auch als Glasumwandlungstemperatur oder Erweichungstemperatur bezeichnet wird, ist die Grenztemperatur, bei deren Überschreiten ganz oder teilweise amorphe Polymerwerkstoffe, wie die üblicherweise als Bestandteil des Trägermaterials eingesetzten Kunststoffe oder Kunstharze, von einem starren, glasartig-hartelastischen Zustand in einen flüssigen oder teigigen, flexiblen Zustand übergehen. Bei den üblichen Trägermaterialien von Leiterplatten liegt die Glasübergangstemperatur Tg bei ca. 100°C-120°C, bei speziellen Hoch-Tg-Leiterplatten auch bis zu 180°C. Im normalen Betrieb muss die dauerhafte thermische Belastung ca. 25°C unterhalb von Tg bleiben. Beim Überschreiten der spezifischen Tg erfolgt zunächst ein Erweichen des Materials, so dass es plastisch verformbar wird. Bei noch höheren Temperaturen oberhalb einer spezifischen Zersetzungstemperatur > 300°C erfolgt eine Delamination und eine strukturelle Zersetzung der Polymermatrix. Ein Vorteil des erfindungsgemäßen Verfahrens ist, dass Prozesstemperaturen zwischen etwa 100°C und 300°C prozesstechnisch gut beherrschbar sind. Insbesondere sind die üblicherweise aus Kupfer bestehenden Leiterbahnen umempfindlich gegenüber diesen Prozesstemperaturen bei der Modifikation des Trägermaterials, wodurch eine hohe Fertigungssicherheit gewährleistet werden kann.

Es ist auch denkbar und möglich, dass die Temperatur bei der Bearbeitung lokal über die Zersetzungstemperatur erhöht wird, wodurch eine lokal definierte Zerstörung der Polymerstruktur erzeugt werden kann. Dadurch kann eine strukturelle Schwächung zur Erhöhung der Flexibilität ohne äußere Maß oder Formänderung erzeugt werden.

Es kann vorgesehen sein, dass das Trägermaterial ein Kunstharz aufweist. Als gängiges Trägermaterial von Leiterplatten wird Epoxidharz eingesetzt, zumeist als faserverstärktes Verbundmaterial, beispielsweise in Form von glasfaserverstärktem Kunststoff (GFK). Derartige Trägermaterialen sind haben eine hohe Festigkeit, was für die mechanische Haltbarkeit vorteilhaft ist, jedoch die im Stand der Technik bekannte spanende Bearbeitung zur Erzeugung eines flexiblen Verbindungsabschnitts fertigungstechnisch aufwendig macht. Für die die weit verbreiteten Trägermaterialen der Klasse FR4, einem Epoxidharz-Glasgewebe-Verbundwerkstoff, liegt Tg bei ca.100°C-120°C , für spezielle Hoch-Tg-Materialien bis zu ca. 180°C. Für das erfindungsgemäße Verfahren ist es ausreichend, das Kunstharz lokal über Tg zu erwärmen, wodurch eine plastische Umformung auch von faserverstärktem Verbundmaterial ermöglich wird. Auch eine Erwärmung bis über die spezifische Zersetzungstemperatur der Harzmatrix des Kunstharzes ist möglich, wodurch beispielsweise eine Delaminierung von den Verstärkungsfasern erfolgen kann, so dass beispielsweise die Glasfasern im Verbindungsabschnitt biegeweich und flexibel, aber weiterhin eine hohe Reißfestigkeit bieten. In jedem Fall kann ein geringerer Fertigungsaufwand als im Stand der Technik realisiert werden.

Es kann wie vorangehend beschrieben vorgesehen sein, dass zur thermischen Modifizierung das Trägermaterial thermisch erweicht wird, und in dem erweichten Zustand eine plastische Umformung erfolgt. Dazu kann zunächst kann ein Leiterplattenrohling mit einer Gesamtfläche umfassend die Leiterplattenabschnitte und den oder die Verbindungsabschnitte bereitgestellt werden, der eine einheitliche Dicke hat, also eine über seine Gesamtfläche gleichmäßig durchgehend Materialstärke senkrecht zur Flächenerstreckung gemessen. Auf dem Leiterplattenrohling werden Leiterbahnen ausgebildet, beispielsweise in an sich bekannter Weise in einer auf das Trägermaterial aufkaschierten Kupferschicht. Dabei können Leiterbahnen in den starren Leiterplattenabschnitten beidseitig auf der Ober- und Unterseite angeordnet sein, und dort mit aufgelöteten elektrischen Bauteilen verbunden sein. In dem flexiblen Verbindungsabschnitt sind Leiterbahnen bevorzugt nur einseitig, definitionsgemäß auf der Oberseite des Trägermaterials angeordnet. Wie vorangehend erläutert ist, kann durch die erfindungsgemäße thermische Modifikation eine plastische Umformung erzeugt werden, durch die im Bereich des Verbindungsabschnitts eine dauerhafte Formveränderung erzeugt wird, beispielsweise eine Dickenreduzierung. Zusätzlich oder alternativ kann auch eine thermische Strukturveränderung des Trägermaterials erfolgen.

Es kann vorgesehen sein, dass zur plastischen Umformung ein Umformstempel eingepresst wird um die Dicke in dem Verbindungsabschnitt relativ zur Dicke in den Leiterplattenabschnitten zu verringern. Dazu wird das Trägermaterial thermisch erweicht, und durch den negativen Abdruck des Umformstempels eine Verdünnung des Trägermaterials erzeugt. Bevorzugt kann dazu ein als Umformstempel oder Pressstempel Umformwerkzeug um eine vorgegebene Tiefe gemessen von der Oberfläche des Verbindungsabschnitts in das Trägermaterials eingeformt werden. Ein derartigen Verfahren ist fertigungstechnisch mit geringem Aufwand zuverlässig umsetzbar. Weiter bevorzugt ist der Umformstempel oder Pressstempel derart ausgebildet, dass er in sich selbst erwärmt werden kann und dadurch die für die Erweichung des Trägermaterials erforderliche Aufwärmung unmittelbare während der Umformung und/oder der Einprägung in das Trägermaterial einbringt. Als Heizelement kann beispielsweise ein direkt bestrombares Widerstandselement in dem Umformstempel integriert sein. Zur Erwärmung kann der Umformstempel beispielsweise in einfacher Weise elektrisch bestromt werden.

Alternativ oder zusätzlich ist es möglich, dass bei der thermischen Modifizierung das Trägermaterial zumindest partiell zersetzt wird. Wie oben beschrieben kann durch eine lokale Erwärmung oberhalb der materialspezifischen Zersetzungstemperatur eine irreversible strukturelle Veränderung des Trägermaterials erfolgen, wodurch die lokale Festigkeit verringert werden kann. Dabei kann die Dicke im Wesentlichen gleich bleiben, oder es kann ein Materialabtrag erfolgen, beispielsweise um die Dicke zu verringern.

Die Erwärmung kann mittels Kontaktwärmeübertragung erfolgen. Hierzu kann ein oberhalb der Glasübergangstemperatur erwärmter Heizstempel mit der freien, rückseitigen Oberfläche des Trägermaterials in Kontakt gebracht werden. Durch den Wärmeübergang erweicht das Trägermaterial von der Oberseite her. In das erweichte Trägermaterial kann ein Umformstempel eingepresst und abgeformt werden. Dabei kann der Heizstempel auch gleichzeitig als Umformstempel oder Pressstempel ausgebildet sein, der in das durch Erwärmung erweichte Trägermaterial eingepresst wird. Dies ermöglicht eine fertigungstechnisch einfache Umsetzung.

Alternativ oder zusätzlich kann vorgesehen sein, dass die Erwärmung mittels Strahlung und/oder mittels Ultraschallanregung und/oder mittels kapazitiver Anregung erfolgt. Beispielsweise kann das Trägermaterial räumlich definiert mittels Laser erweicht oder aufgeschmolzen werden, um im Anschluss einen Presstempel oder dergleichen einzuformen. Dadurch kann mit geringen Aufwand eine definierte Wärmemenge räumlich definiert in das Trägermaterial eingekoppelt werden, um eine hohe Reproduzierbarkeit und rationelle Fertigung gewährleistet ist. Es ist auch denkbar und möglich, Wärmeenergie per Ultraschallanregung über eine Sonotrode einzukoppeln, die auch als Presstempel ausgebildet sein kann. Eine weitere Möglichkeit ist, die Wärme durch ein elektrisches Wechselfeld das Dielektrikum des Trägermaterials einzukoppeln.

Es kann vorteilhaft sein, dass eine zum Erwärmen des Trägermaterial eine vorbestimmte Wärmemenge eingekoppelt wird. Durch den der Wärmemenge entsprechenden Energiebetrag kann erreicht werden, dass eine definierte Menge des Trägermaterials auf eine definierte Temperatur erwärmt wird. Um pro thermisch zu modifizierenden Verbindungsabschnitt eine definierte Wärmemenge bereitzustellen, kann beispielsweise ein Wärmekontakt mit einem auf eine spezifische Temperatur erwärmten Heizstempel für eine bestimmte Zeit erzeugt werden, oder ein Laser mit bestimmter Energie und einem gegebenen Absorptionsgrad des Trägermaterials kann für eine bestimmte Zeit auf einen definierten Flächenabschnitt gestrahlt werden.

Es ist möglich, dass die Leiterplatte vor der thermischen Modifikation mit elektrischen Bauteilen bestückt wird. Die elektrischen Bauteile werden zur Ausbildung der Steuerschaltung mit den Leiterbahnen verlötet. Ein Vorteil des erfindungsgemäßen Verfahren ist, dass potentielle Schäden durch mechanische Belastungen weitgehend ausgeschlossen werden können.

Es kann vorteilhaft sein, dass der Verbindungsabschnitt und/oder die Leiterplattenabschnitte während der Erwärmung außerhalb des erwärmten Bereichs gekühlt werden. Beispielsweise kann eine Wärmableitung über Kontaktflächen erfolgen, so dass außerhalb der thermisch zu bearbeitenden Bereiche das Trägermaterial unterhalb der Glasübergangstemperatur gehalten wird, so dass dort keine Erweichung erfolgt. Die Kühlung kann von der gegenüberliegenden Leiterbahnseite aus erfolgen, welche der Wärmeeinleitung gegenüberliegt. Dadurch werden die Leiterbahnen und die Bauteile sicher vor Erwärmung geschützt. Eine Kühlung kann auch seitlich außerhalb des erwärmten Bereichs erfolgen. Zur Kühlung kann ein gekühlter Wärmeleiter mit der Oberfläche in Wärmeleitkontakt gebracht werden. Es kann auch eine Kühlung durch einen gerichteten Luft- oder Gasstrom ausreichend sein.

Die Leiterplattenabschnitte können in dem Verbindungsabschnitt relativ zueinander umgebogen werden. Dabei können jeweils für den Einsatzzweck vorteilhafte Winkellagen der Leiterplattenabschnitte zueinander eingestellt werden. Nach der Erwärmung kann der Verbindungsabschnitt durch die thermische Modifizierung eine dauerhaft reduzierte Biegesteifigkeit aufweisen, so dass er elastisch umgebogen werden kann, um die Leiterplatte bei der Montage zu falten. Es kann auch eine plastische Biegeverformung erfolgen. Alternativ kann die Biegung auch in dem erwärmten Zustand erfolgen, solange das Trägermaterial thermisch erweicht ist.

Ein Verfahren zur Herstellung eines Lenksystems für ein Kraftfahrzeug, bei dem eine elektronische Bauteile einer Steuerschaltung aufweisende halbflexible Leiterplatte, die zumindest zwei im Wesentlichen starre, über einen biegbaren Verbindungsabschnitt miteinander verbundene Leiterplattenabschnitte aufweist, im Bereich des Verbindungsabschnitts umgebogen und an dem Lenksystem angebracht wird, sieht erfindungsgemäß vor, dass die Leiterplatte gemäß dem vorangehend beschriebenen Verfahren erzeugt wird. Dabei können die beschriebenen Verfahrensmerkmale einzeln oder in verfahrenstechnisch sinnvollen Kombinationen angewendet werden.

Eine Steuerschaltung für ein Lenksystem eines Kraftfahrzeugs, umfassend eine halbflexible Leiterplatte, die eine aus einem isolierenden Trägermaterial ausgebildete Trägerplatte mit darauf angeordneten Leiterbahnen aus einem leitfähigen Material aufweist, die mit elektrischen Bauteilen verbunden sind, wobei die Leiterplatte zumindest zwei im wesentlichen starre Leiterplattenabschnitte aufweist, die über einen biegbaren Verbindungsabschnitt miteinander verbunden sind, zeichnet sich erfindungsgemäß dadurch aus, dass der Verbindungsabschnitt eine thermische Modifizierung aufweist, in dem die Biegesteifigkeit relativ zu den starren Leiterplattenabschnitten reduziert ist. Eine thermische Modifizierung ist eine Form- und/oder Strukturänderung, die gemäß dem oben beschriebenen erfindungsgemäßen Verfahren erzeugt wird. Eine derartige thermische Modifizierung unterscheidet sich spezifisch von einer im Stand der Technik bekannten spanenden Bearbeitung, beispielsweise hinsichtlich der dabei mechanisch durchtrennten Gefüge- und Materialstrukturen.

Ein Lenksystem für ein Kraftfahrzeug, umfassend eine auf einer Leiterplatte aufgebaute elektrische Steuerschaltung, zeichnet sich erfindungsgemäß dadurch aus, dass die Steuerschaltung wie vorangehend beschrieben erfindungsgemäß ausgestaltet ist. Bevorzugt weist das Lenksystem eine Lenksäule zur manuellen Eingabe von Lenkbefehlen auf. Die Lenksäule kann bevorzugt eine manuelle Lenkhandhabe aufweisen, und eine elektrische Sensoranordnung zur Erfassung von Lenkbefehlen. Weiterhin kann bevorzugt eine motorische Antriebseinheit vorgesehen sein, wie beispielsweise ein elektrischer Hilfskraftantrieb oder ein Feedback-Aktuator (FbA), die an die Steuerschaltung angeschlossen sind.

Die Leiterplatte kann im Bereich des Verbindungsabschnitts in eine gewünschte Winkellage zueinander umgebogen und auf diese Weise zusammengefaltet, in einem bevorzugt geschlossenen Gehäuse angeordnet, welches an der Lenksäule ausgebildet sein kann, und/oder an einer anderen Stelle des Lenksystems. Dadurch wird ein kompakter Aufbau ermöglicht.

Besonders bevorzugt ist es, wenn die Leiterplattenabschnitte um etwa 90° oder 180° zueinander umgebogen sind. Unter dem Begriff "etwa" ist ein Winkelbereich mit einer Abweichung von +10° bis -10° zu verstehen. Das heißt Winkel im Bereich von 80° bis 100° oder von 170° bis 190°. Dadurch können günstige Konstellationen für die gesamte jeweilige Steuerung, in die die Leiterplatte beziehungsweise die Steuerschaltung, die auf der Leiterplatte angeordnet ist, eingebaut wird, erreicht werden.

Es kann aber auch sinnvoll sein, die Leiterplattenabschnitte um andere Winkel zueinander gebogen in Position zu bringen. Dadurch kann eine Anpassung an einen zur Verfügung stehenden Bauraum erfolgen.

### Beschreibung der Zeichnungen

Vorteilhafte Ausführungsformen der Erfindung werden im Folgenden anhand der Zeichnungen näher erläutert. Im Einzelnen zeigen:
- Figur 1: eine schematische Ansicht auf die Oberseite (Leiterbahnseite) der Leiterplatte einer erfindungsgemäßen Steuerschaltung (Draufsicht),
- Figur 2: eine schematische Ansicht auf die Unterseite (Trägerplattenseite) der Leiterplatte gemäß Figur 1 während einer thermischen Modifizierung,
- Figur 3: die Leiterplatte gemäß Figur 2 während der thermischen Modifizierung mittels des erfindungsgemäßen Verfahrens in einer Seitenansicht,
- Figur 4: die Leiterplatte gemäß Figur 3 mit einem fertigen, eine thermische Modifizierung aufweisenden Verbindungsabschnitt,
- Figur 5: die Steuerschaltung mit der Leiterplatte gemäß Figur 4 in einem gebogenen, einbaufertigen Zustand,
- Figur 6: eine Leiterplatte in einer Ansicht ähnlich Figur 3 während eines ersten Schritts einer thermischen Modifizierung,
- Figur 7: die Leiterplatte gemäß Figur 6 in einem Zwischenzustand nach dem ersten Schritt gemäß Figur 6,
- Figur 8: die Leiterplatte gemäß Figur 7 in einer Ansicht ähnlich Figur 6 während eines zweiten Schritts einer thermischen Modifizierung,
- Figur 9: die Leiterplatte gemäß Figur 8 in einem fertigen Zustand nach dem zweiten Schritt gemäß Figur 6,
- Figur 10: die Steuerschaltung mit der Leiterplatte gemäß Figur 9 in einem zusammengefalteten, einbaufertigen Zustand,
- Figur 11: eine schematische Ansicht auf die Unterseite (Trägerplattenseite) der Leiterplatte ähnlich Figur 2 während einer thermischen Modifizierung gemäß einer weiteren Ausführung des erfindungsgemäßen Verfahrens,
- Figur 12: die Leiterplatte gemäß Figur 11 während der thermischen Modifizierung in einer Seitenansicht ähnlich Figur 3,
- Figur 13: eine Leiterplatte in einer Seitenansicht ähnlich Figur 3 oder 12 während der thermischen Modifizierung mittels eines Laserstrahls,
- Figur 14: eine weitere Ansicht ähnlich Figur 13,
- Figur 15: eine Leiterplatte in einer Seitenansicht ähnlich Figur 3, 12 oder 13 während der thermischen Modifizierung mittels Ultraschall,
- Figur 16: die Steuerschaltung mit der Leiterplatte in einer weiteren Ausführungsform in einem gebogenen, einbaufertigen Zustand,
- Figuren 17 und 18: jeweils eine alternative Ausführung von möglichen Anordnungen der Verbindungsbereiche von erfindungsgemäßen Steuerschaltungen,
- Figur 19: die Steuerschaltung mit der Leiterplatte in einer weiteren Ausführungsform in einem gebogenen, einbaufertigen Zustand,
- Figur 20: ein erfindungsgemäßes Lenksystem eines Kraftfahrzeugs in einer schematischen perspektivischen Ansicht.

### Ausführungsformen der Erfindung

In den verschiedenen Figuren sind gleiche Teile stets mit den gleichen Bezugszeichen versehen und werden daher in der Regel auch jeweils nur einmal benannt bzw. erwähnt.

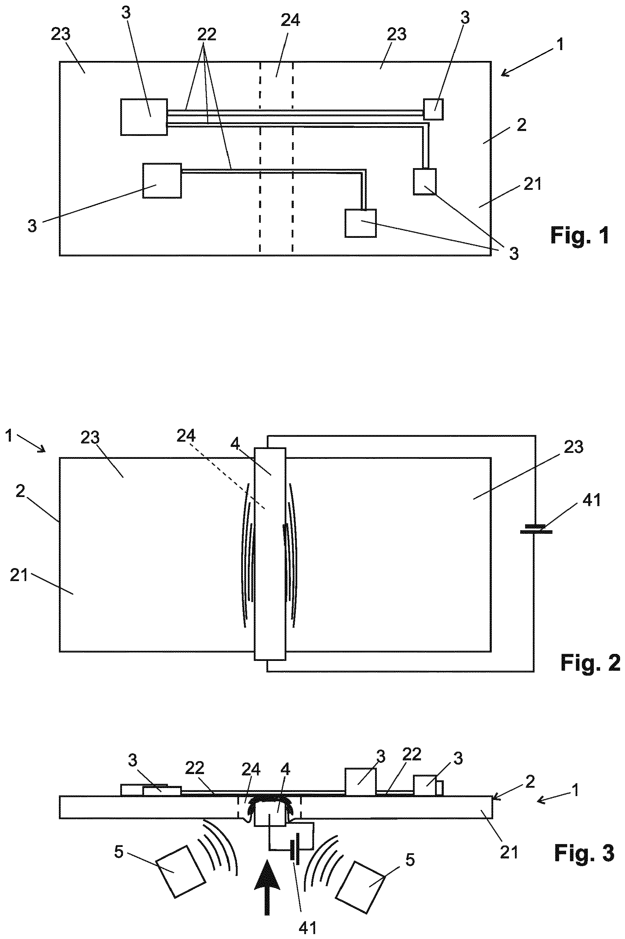

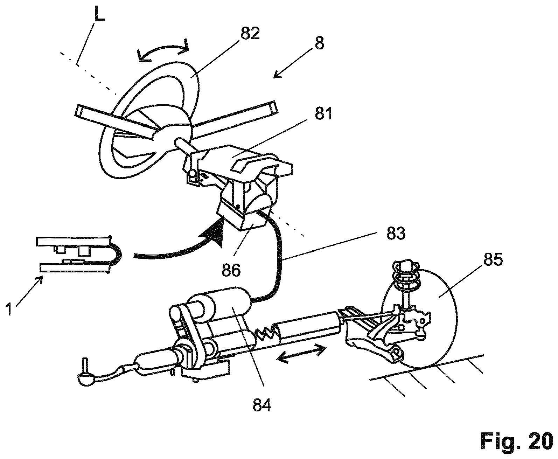

Fig. 1 zeigt eine Steuerschaltung 1 für ein Lenksystem eines Kraftfahrzeugs (siehe Bezugszeichen 8 in Figur 20) in einer Ansicht von oben auf die Oberseite oder Leiterbahnseite einer Leiterplatte 2 in einer Ausgangssituation. Die Leiterplatte 2 weist eine Trägerplatte 21 aus einem plattenförmigen isolierenden Trägermaterial auf, die beispielsweise aus einen glasfaserverstärkten Kunstharz (GFK) ausgebildet ist, beispielsweise auf einem Trägermaterial der Klasse FR4. Darauf sind auf der Oberseite Leiterbahnen 22 aus einem Leitermaterial angebracht, beispielsweise aus Kupfer. Mit den Leiterbahnen 22 sind elektronische Bauteile 3 durch Lötverbindungen leitend verbunden. Die Anordnung ist in der Seitenansicht von Figur 3 erkennbar.

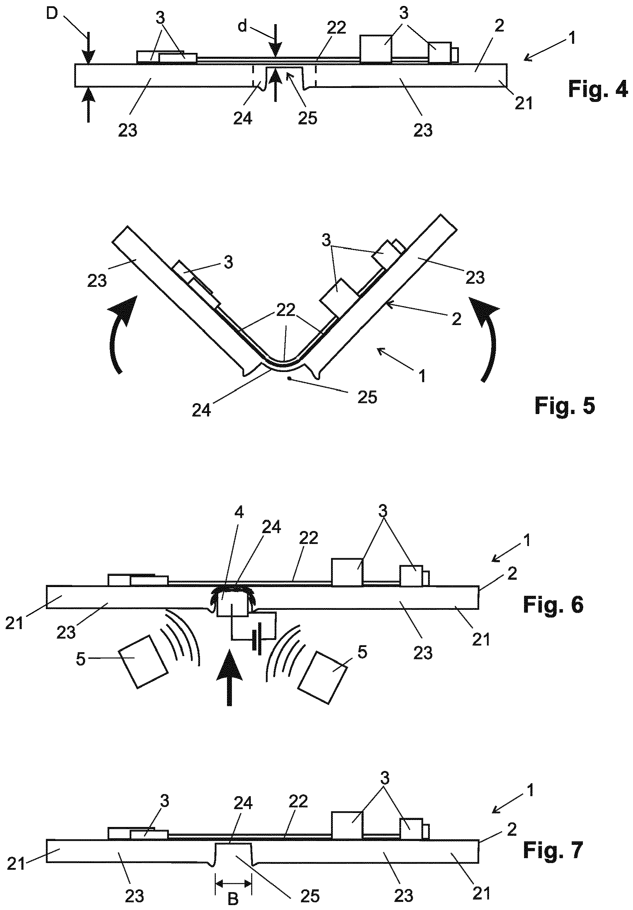

Im einbaufertigen Zustand weist die Leiterplatte 2 im gezeigten Beispiel zwei starre, flächig erstreckte Leiterplattenabschnitte 23 auf, welche die Bauteile 3 tragen. Diese Leiterplattenabschnitte 23 sind über einen relativ dazu flexibleren, d.h. biegeweicheren Verbindungsabschnitt 24 biegbar miteinander verbunden, wie dies beispielsweise in Fig. 5 veranschaulicht ist.

Der Verbindungsabschnitt 24 weist eine mittels des erfindungsgemäßen Verfahrens in die Unterseite der Trägerplatte 21 in das Trägermaterial eingebrachte, rinnen- oder nutförmige Einformung 25 auf, gleichbedeutend auch als thermische Modifikation bezeichnet wird, und die in der Seitenansicht der Figuren 3 bis 5 gut erkennbar ist.

In den starren Leiterplattenabschnitten 23 weist die Trägerplatte 21 eine Dicke D auf, welche der Trägermaterialstärke des Leiterplatten-Rohmaterials entspricht. Durch die Einformung 25 ist die Dicke d im Verbindungsabschnitt 24 relativ dazu reduziert. Mit anderen Worten ist in dem Verbindungsabschnitt 24 eine Trägermaterialverdünnung oder -reduzierung realisiert, wodurch dort die Biegesteifigkeit reduziert ist.

In den Figuren 2 bis 5 ist die Erzeugung eines erfindungsgemäßen Verbindungsabschnitts mit einer thermisch erzeugten Einformung 25 (Trägermaterialverdünnung oder -reduzierung) gemäß einer ersten Ausführung eines erfindungsgemäßen Verfahrens gezeigt. In den Figuren 6 bis 10 ist eine zweite Weiterbildungsmöglichkeit eines erfindungsgemäßen Verfahrens gezeigt.

Gemäß einer ersten Variante kann die Einformung 25 mittels eines thermischen Umformstempels 4 erfolgen. Dieser kann in etwa balkenförmig ausgebildet sein und sich über die gesamte Breite des Verbindungsabschnitts erstrecken. Der Umformstempel 4 weist ein elektrisches Heizelement auf, welches an eine elektrische Stromquelle 41 angeschlossen ist und dadurch auf eine Umformtemperatur aufgeheizt wird, die oberhalb der Erweichungstemperatur, entsprechend der Glasübergangstemperatur Tg des Trägermaterials liegt.

Wie in Figur 3 dargestellt, wird der aufgeheizte Umformstempel 4 von der Unterseite im Bereich des Verbindungsabschnitts 24 in direkten Wärmekontakt mit der dort freiliegenden Trägerplatte 21 gebracht. Durch die dabei auftretende Kontaktwärmeübertragung wird das Trägermaterial dort lokal erweicht bzw. aufgeschmolzen, wobei es in einen teigigen, zähflüssigen Zustand mit verringerter Viskosität kommt. Dadurch kann der Umformstempel 4 - wie mit dem Pfeil in Figur 3 angedeutet ist - von unten in das Trägermaterial eingebracht werden. Gegebenenfalls kann dies durch Aufbringung einer Presskraft in Pfeilrichtung unterstützt werden. Dabei dient der Umformstempel 4 gleichzeitig als Presstempel. Die Einformung wird so weit fortgesetzt, bis die vordefinierte reduzierte Dicke d realisiert ist. Welche reduzierten Dicken d für den Einsatz geeignet sind, kann in Versuchen bestimmt werden.

Durch die Umformtemperatur bleibt das Material der Leiterbahnen 22, beispielsweise metallisches Kupfer, in seinen Materialeigenschaften praktisch unverändert, und es können keine unerwünschten Verformungen oder mechanische Beschädigungen auftreten, wie potentiell bei den im Stand der Technik bekannten Fräsverfahren oder dergleichen. Auch wird die elektrische Isolation der Leiterbahnen 22 nicht beschädigt.

Im Ergebnis wird der Umformstempel 4 von unten negativ in der Trägerplatte 21 plastisch abgeformt, und eine der Kontur des Umformstempels 4 entsprechende Einformung 25 ausgebildet, wie in Figur 4 erkennbar ist.

Während der thermischen Umformung kann eine Kühlung der nicht ungeformten Leiterplattenabschnitte 23 erfolgen, beispielsweise mittels einer Kühleinrichtung 5, die einen wärmeabführenden Luftstrom erzeugen kann, oder über Kontaktwärmeübertragung Wärme von der Leiterplatte 2 abführen kann.

Durch die reduzierte Dicke d ist die Leiterplatte 2 im Verbindungsbereich 24 flexibel, es wird mit anderen Worten eine halbflexible Leiterplatte 2 ausgebildet. Dadurch können die starren Leiterplattenabschnitte 23 unter Biegeverformung des Verbindungsabschnitts 24 und der darüber verlaufenden Leiterbahnen 22 gegeneinander gebogen werden, wie in Figur 5 mit den gebogenen Pfeilen angedeutet ist. Dabei kann die Umbiegung so weit fortgesetzt werden, wie es für den Einbau in die gewünschte Steuerung erforderlich ist. Entsprechend dem Ausführungsbeispiel der Figuren 2 bis 5 ist eine Winkellage der beiden starren Leiterplattenabschnitte 23 von etwa 90° vorgesehen. Entsprechend ist damit die Leiterplatte 2 von der Ausgangssituation gemäß Figur 1 in die Einbausituation gemäß Fig. 5 überführt. In diesem Zustand ist die Steuerschaltung 1 einbaufertig zusammengefaltet.

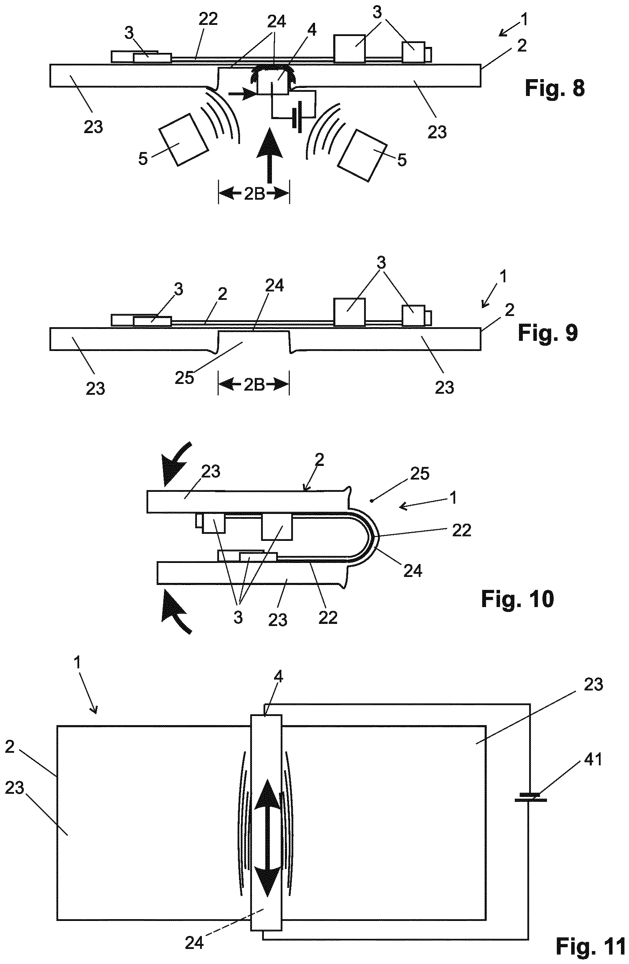

Es kann aber auch vorgesehen sein, die beiden Leiterplattenabschnitte bis zu etwa 180°, wie in Figur 10 gezeigt, um die Steuerschaltung 1 platzsparend zusammenzufalten.

In den Figuren 6 bis 10 ist eine Weiterbildung des erfindungsgemäßen Verfahren gezeigt. Dabei wird zunächst wie in den Figuren 6 und 7 gezeigt mittels des thermischen Umformstempels 4 eine Einformung der Breite B eingebracht, welche der Breite des Umformstempels entspricht.

Im nächsten Schritt gemäß Figur 8 wird der Umformstempel 4 seitlich versetzt, etwa um den Betrag der Breite B, und nochmals in das Trägermaterial eingeformt. Dadurch kann eine Einformung 25 mit der doppelten Breite 2B erzeugt werden, wie in Figur 9 dargestellt ist. Es ist dabei ohne weiteres denkbar und möglich, auf größere Breiten durch mehrmaliges Anwenden diese Technik zu erreichen. Alternativ kann mit dieser Technik auch nur eine Breite von etwas mehr als 1B zu erreicht werden.

Anschließend kann die Leiterplatte 2 im Bereich des Verbindungsabschnitts 24 umgebogen werden, beispielsweise um etwa 180°, bis die beiden Leiterplattenabschnitte 23 einander gegenüberliegen, wie in Figur 10 gezeigt ist. Entsprechend ist damit die Leiterplatte 2 von der Ausgangssituation gemäß Figur 1 in die Einbausituation gemäß Fig. 10 entsprechend der zweiten Ausführungsform überführt. In diesem Zustand ist die Steuerschaltung 1 einbaufertig kompakt zusammengefaltet.

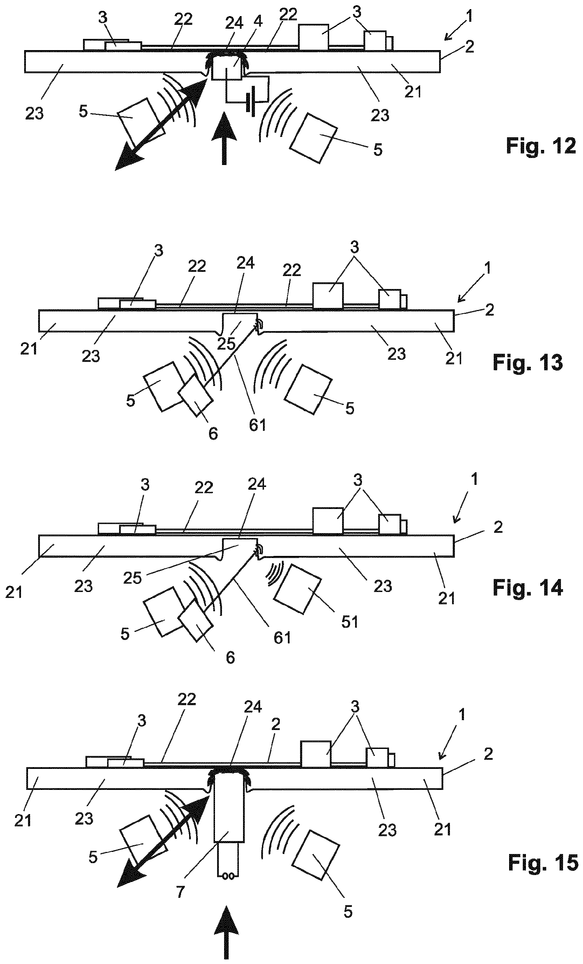

Figuren 11 und 12 zeigen schematische Darstellungen einer Weiterbildung des erfindungsgemäßen Verfahrens in Ansichten ähnlich wie in den Figuren 2 und 3. Darin kann der Umformstempel 4 zusätzlich in der Ebene der Leiterplatte 2 bewegt werden, wie in Figur 11 mit dem Doppelpfeil angedeutet, und alternativ oder zusätzlich quer dazu, wie in Figur 12 mit dem Doppelpfeil angedeutet ist. Dadurch ist es möglich, dass das Trägerplattenmaterial beim Einbringen des Umformstempels 4 abgetragen und von der Trägerplatte 21 entfernt wird.

In den Figuren 13 und 14 ist eine Alternative der erfindungsgemäßen thermischen Modifikation mittels eines Lasers 6 gezeigt. Dieser kann den Verbindungsabschnitt 24 lokal mittels eines Laserstrahls 61 erwärmen. Die Erwärmung kann im Bereich oberhalb der Glasübergangstemperatur Tg liegen, so dass eine Einformung 25 mittels eines Umformwerkzeugs 4 ähnlich wie in den vorangehend erläuterten Verfahren ermöglicht wird. Es kann auch vorteilhaft sein, dass mittels hochenergetischer Laserpulse eine Erwärmung bis über die Zersetzungstemperatur erfolgt, so dass das Trägermaterial lokal verdampft und dadurch thermsich abgetragen wird. Auf diese Weise kann durch sukzessive thermische Laserbearbeitung eine Einformung 25 mit exakt vorgegebener Breite und Teile erzeugt werden.

Mittels der Kühleinrichtungen 5 kann die Trägerplatte 2 außerhalb des mittels des Laserstrahls 61 erhitzten Bearbeitungsbereichs wirksam gekühlt werden, um dort eine Erwärmung zu vermeiden. Gleichzeitig können durch die Kühleinrichtung 5 die gelösten Partikel der Trägerplatte 2 aus dem Arbeitsbereich herausgeschleudert werden. Wie in Fig. 14 veranschaulicht kann auch eine Absaugeinrichtung 51 vorgesehen sein, die die Dämpfe und die die gelösten Partikel der Trägerplatte 2 absaugen.

In Figur 15 ist eine weitere Möglichkeit zur Umsetzung einer erfindungsgemäßen thermischen Modifikation in einer Ansicht analog Figur 12 gezeigt. Darin wird als Umformwerkzeugt eine Sonotrode 7 eingesetzt, die einen mit Ultraschallschwingungen beaufschlagten Umformstempel bildet. Durch die Einkopplung der Ultraschallenergie wird die Trägerplatte 2 durch den Kontakt der Sonotrode 7 im Verbindungsabschnitt 24 erwärmt und dadurch erweicht. Die Sonotrode 7 kann dann analog zu dem Umformstempel 4 gemäß der vorgenannten Ausführungen eingeformt werden.

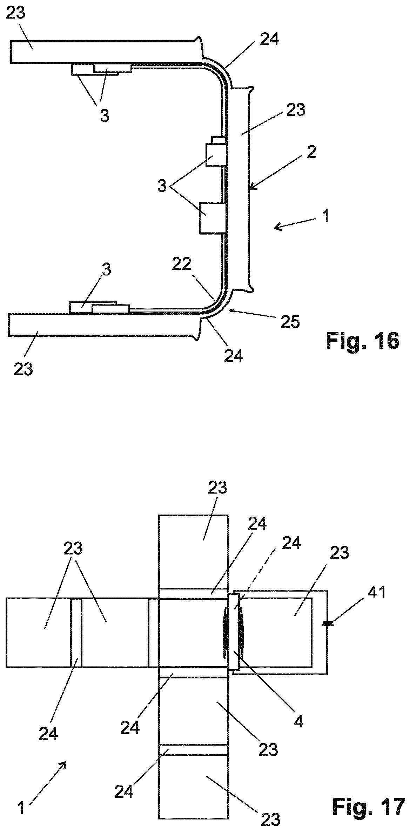

In Figur 16 ist eine Steuerschaltung 1 mit der Leiterplatte veranschaulicht, die aus drei Leiterplattenabschnitten 23 gebildet ist, die jeweils zueinander eine definierte Ausrichtung aufweisen. Im Beispiel sind die drei Leiterplattenabschnitte 23 in Form eine offenen U-Profils zueinander ausgerichtet. Diese einbaufertige Steuerschaltung 1 kann in eine dafür vorgesehene Steuerung eingebaut werden.

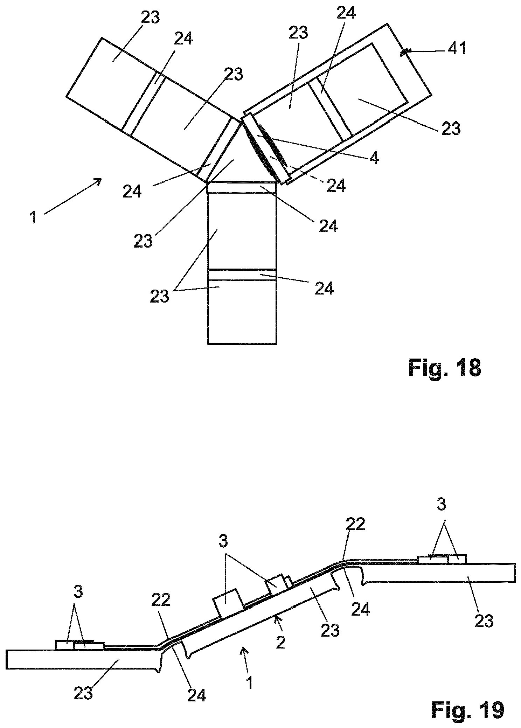

Es sind ohne weiteres auch mehr als drei Leiterplattenabschnitte 23 denkbar und möglich, wobei diese auch in verschiedene Richtungen durch Verbindungsabbereiche 24 verbunden sein können. In den Figuren 17 und 18 sind dafür zwei Beispiele veranschaulicht. Dabei können auch dreieckige Grundformen für einen oder mehrere der Leiterbahnabschnitte vorgesehen sein, wie dies in Figur 18 veranschaulicht ist.

Auch ist es denkbar und möglich, einzelne der Leiterplattenabschnitte 23 um positive Winkelgrade und einige der Leiterplattenabschnitte 23 um negative Winkelgrade zueinander zu verbiegen bzw. gewinkelt anzuordnen, um eine Anpassung an entsprechende Gehäusekonturen zu erreichen. Ein Beispiel dafür ist in Figur 19 veranschaulicht.

In Figur 20 ist ein erfindungsgemäß ausgestaltetes Steer-by-wire-Lenksystem 8 für ein Kraftfahrzeug dargestellt. Dieses umfasst eine Lenksäule 81 mit einer manuellen Lenkhandhabe in Form einer um eine Längsachse L drehbaren Lenkwelle mit einem daran angebrachten Lenkrad 82. Als manuelle Drehung des Lenkrads 82 eingegebene Lenkbefehle werden mittels nicht dargestellter elektronischer Drehsensoren erfasst und einer Steuerschaltung 1 zugeführt. Diese erzeugt den Lenkbefehlen entsprechende elektrische Steuersignale, die über eine elektrische Leitung 83 einen elektrischen Lenksteller 84 ansteuern, der einen mechanischen Lenkeinschlag der lenkbaren Räder 85 bewirkt.

Die gemäß einem der vorbeschriebenen Verfahren mit einer thermisch erzeugten Einformung 25 versehene Steuerschaltung 1 kann wie in Figur 10 gezeigt kompakt zusammengefaltet und im Inneren eines Steuerungsgehäuses 86 geschützt untergebracht und an die Sensoren und den Lenksteller 84 angeschlossen sein, wie mit dem Pfeil angedeutet ist. Das Steuerungsgehäuse 86 kann wie gezeigt an der Lenksäule 81 angebracht sein.

### Bezugszeichenliste

- 1: Steuerschalteung
- 2: Leiterplatte
- 21: Trägerplatte
- 22: Leiterbahnen
- 23: Leiterplattenabschnitte
- 24: Verbindungsabschnitt
- 25: Einformung
- 4: Umformstempel
- 41: Stromquelle
- 5: Kühleinrichtung
- 51: Absaugeinrichtung
- 6: Laser
- 61: Laserstrahl
- 7: Sonotrode
- 8: Lenksystem
- 81: Lenksäule
- 82: Lenkrad
- 83: Leitung
- 84: Lenksteller
- 85: Rad
- 86: Steuerungsgehäuse

- D: Dicke der Leiterplattenabschnitte 23
- d: Dicke des Verbindungsabschnitts 24
- B: Breite des Umformstempels 4
- L: Längsachse
- Tg: Glasübergangstemperatur

## Patentansprüche

1. Verfahren zur Herstellung einer Steuerschaltung (1) für ein Lenksystem (8) eines Kraftfahrzeugs, umfassend eine halbflexible Leiterplatte (2), die ein isolierendes Trägermaterial mit darauf angeordneten Leiterbahnen (22) aus einem leitfähigen Material aufweist, die mit elektrischen Bauteilen (3) verbunden sind, wobei die Leiterplatte (2) zumindest zwei im wesentlichen starre Leiterplattenabschnitte (23) aufweist, die über einen biegbaren Verbindungsabschnitt (24) miteinander verbunden sind,
**dadurch gekennzeichnet,**
**dass** in dem Verbindungsabschnitt (24) durch zumindest abschnittweise Erwärmung des Trägermaterials auf eine Umformtemperatur eine thermische Modifizierung (25) erzeugt wird zur Reduzierung der Biegesteifigkeit.

2. Verfahren nach Anspruch 1, **dadurch gekennzeichnet, dass** die Umformtemperatur oberhalb einer Glasübergangstemperatur (Tg) des Trägermaterials liegt.

3. Verfahren nach einem der vorangehenden Ansprüche, **dadurch gekennzeichnet, dass** das Trägermaterial ein Kunstharz aufweist.

4. Verfahren nach einem der vorangehenden Ansprüche, **dadurch gekennzeichnet, dass** zur thermischen Modifizierung das Trägermaterial thermisch erweicht wird, und in dem erweichten Zustand eine plastische Umformung erfolgt.

5. Verfahren nach Anspruch 4, **dadurch gekennzeichnet, dass** zur plastischen Umformung ein Umformstempel (4) eingepresst wird um die Dicke (d) in dem Verbindungsabschnitt (24) relativ zur Dicke (D) in den Leiterplattenabschnitten (23) zu verringern.

6. Verfahren nach einem der vorangehenden Ansprüche, **dadurch gekennzeichnet, dass** bei der thermischen Modifizierung das Trägermaterial zumindest partiell zersetzt wird.

7. Verfahren nach einem der vorangehenden Ansprüche, **dadurch gekennzeichnet, dass** die Erwärmung mittels Kontaktwärmeübertragung erfolgt.

8. Verfahren nach einem der vorangehenden Ansprüche, **dadurch gekennzeichnet, dass** die Erwärmung mittels Strahlung und/oder mittels Ultraschallanregung und/oder mittels kapazitiver Anregung erfolgt.

9. Verfahren nach einem der vorangehenden Ansprüche, **dadurch gekennzeichnet, dass** die die Leiterplatte (2) vor der thermischen Modifikation mit elektrischen Bauteilen (3) bestückt wird.

10. Verfahren nach einem der vorangehenden Ansprüche, **dadurch gekennzeichnet, dass** der Verbindungsabschnitt (24) und/oder die Leiterplattenabschnitte (23) während der Erwärmung außerhalb des erwärmten Bereichs gekühlt werden.

11. Verfahren nach einem der vorangehenden Ansprüche, **dadurch gekennzeichnet, dass** die Leiterplattenabschnitte (23) in dem Verbindungsabschnitt (24) relativ zueinander in eine gewünschte Winkellage zueinander umgebogen werden.

12. Verfahren zur Herstellung eines Lenksystems (8) für ein Kraftfahrzeug, bei dem eine elektronische Bauteile (3) einer Steuerschaltung (1) aufweisende halbflexible Leiterplatte (2), die zumindest zwei im Wesentlichen starre, über einen biegbaren Verbindungsabschnitt (24) miteinander verbundene Leiterplattenabschnitte (23) aufweist, im Bereich des Verbindungsabschnitts (24) in eine gewünschte Winkellage zueinander umgebogen und an dem Lenksystem (8) angebracht wird,
**dadurch gekennzeichnet,**
**dass** die Leiterplatte (2) gemäß einem der Ansprüche 1 bis 11 hergestellt wird.

13. Steuerschaltung (1) für ein Lenksystem (8) eines Kraftfahrzeugs, umfassend eine halbflexible Leiterplatte (2), die eine aus einem isolierenden Trägermaterial ausgebildete Trägerplatte (21) mit darauf angeordneten Leiterbahnen (22) aus einem leitfähigen Material aufweist, die mit elektrischen Bauteilen (3) verbunden sind, wobei die Leiterplatte (2) zumindest zwei im wesentlichen starre Leiterplattenabschnitte (23) aufweist, die über einen biegbaren Verbindungsabschnitt (24) miteinander verbunden sind,
**dadurch gekennzeichnet,**
**dass** der Verbindungsabschnitt (24) eine thermische Modifizierung (25) aufweist, in dem die Biegesteifigkeit relativ zu den starren Leiterplattenabschnitten (23) reduziert ist.

14. Steuerschaltung nach Anspruch 13, **dadurch gekennzeichnet, dass** der Verbindungsabschnitt (24) erzeugt ist gemäß einem der Ansprüche 1 bis 11.

15. Lenksystem (8) für ein Kraftfahrzeug, umfassend eine auf einer Leiterplatte (2) aufgebaute elektrische Steuerschaltung (1),
**dadurch gekennzeichnet,**
**dass** die Steuerschaltung (1) ausgestaltet ist gemäß Anspruch 13 oder 14.
